Europäisches Patentamt

European Patent Office

Office européen des brevets

(11) Numéro de publication: **0 198 729 B1**

# FASCICULE DE BREVET EUROPEEN

(45) Date de publication de fascicule du brevet:
20.02.91

(51) Int. Cl.⁵: **G06F 15/60**

(21) Numéro de dépôt: **86400435.3**

(22) Date de dépôt: **28.02.86**

(54) Système de simulation d'un circuit électronique.

(30) Priorité: **08.03.85 FR 8503429**

(43) Date de publication de la demande:
**22.10.86 Bulletin  86/43**

(45) Mention de la délivrance du brevet:
**20.02.91 Bulletin  91/08**

(84) Etats contractants désignés:
**BE DE GB IT NL**

(56) Documents cités:

**PROCEEDINGS OF THE IEEE, vol. 69, no. 10, octobre 1981, pages 1264-1280, New York, US; G.D. HACHTEL et al.: "A survey of third-generation simulation techniques"**

**IEEE TRANSACTIONS ON CIRCUITS AND SYSTEMS, vol. CAS-26, no. 9, septembre 1979, pages 741-749; A.R. NEWTON: "Techniques for the simulation of large-scale integrated circuits"**

**IEEE TRANSACTIONS ON CIRCUITS AND SYSTEMS, vol. CAS-26, no. 9, septembre 1979, pages 733-740; G. RABBAT et al.: "A multilevel Newton algorithm with macromo-**

**deling and latency for the analysis of large-scale nonlinear circuits in the time domain"**

(73) Titulaire: **Hennion, Bernard**
**Les Bonnets**
**F-38410 Saint Martin d'Uriage(FR)**

(72) Inventeur: **Hennion, Bernard**
**Les Bonnets**
**F-38410 Saint Martin d'Uriage(FR)**

(74) Mandataire: **Mongrédien, André et al**
**c/o BREVATOME 25, rue de Ponthieu**
**F-75008 Paris(FR)**

## Description

La présente invention a pour objet un système de simulation d'un circuit électronique permettant de simuler le comportement électrique, dans le temps, d'un circuit électronique déterminé soumis à des conditions électriques de fonctionnement déterminées.

De manière classique, le circuit électronique simulé est décrit comme étant un réseau comportant un certain nombre de noeuds et de branches, chaque branche pouvant comporter un ou plusieurs composants du type résistance, capacité, inductance, transistor ou autre. On définit ensuite les conditions d'alimentation électrique de ce circuit électronique ainsi que la forme du ou des signaux électriques de commande appliqués sur une ou plusieurs entrées de ce circuit.

Un système de simulation reçoit donc une première suite de signaux électriques codés représentatifs de la description du circuit électrique, c'est-à-dire indiquant les noeuds du réseau, les branches reliant chacune deux de ces noeuds et les composants de chaque branche, une deuxième suite de signaux électriques codés représentatifs des conditions électriques de fonctionnement du circuit, une troisième suite de signaux électriques codés représentatifs de la fonction qui existe entre la tension appliquée aux bornes de chacun des composants du circuit (résistance, capacité, inductance, transistor ou autre), ou sa dérivée par rapport au temps, et le courant traversant ledit composant, et une quatrième suite de signaux électriques codés indiquant les noeuds pour lesquels il doit effectuer la simulation de l'état électrique à un instant t déterminé ainsi que la détermination de l'intervalle de temps $\Delta t$ pour la simulation suivante effectuée à l'instant $t + \Delta t$. Les signaux électriques desdites suites sont en général des signaux binaires.

Les systèmes de simulation permettent d'évaluer les performances probables d'un circuit électronique sans qu'il soit nécessaire de réaliser physiquement ce circuit. Ils permettent également de tester rapidement différentes variantes d'un circuit en cours de développement. Les systèmes de simulation sont donc utilisés couramment pour le développement de circuits électroniques.

Chaque système de simulation est défini essentiellement par deux paramètres qui sont, d'une part, le système d'équations différentielles utilisé pour modéliser le circuit électronique et, d'autre part, la méthode employée pour résoudre ce système d'équations différentielles.

Parmi les représentations les plus utilisées, on peut citer les modèles d'Euler, du trapèze et de GEAR. Pour chacun de ces modèles, on peut choisir en fonction du type de circuit électronique simulé et de la précision souhaitée dans le calcul des potentiels des noeuds, d'utiliser ces modèles à l'ordre 1, à l'ordre 2 ou à un ordre supérieur, c'est-à-dire de ne prendre en compte respectivement que la dérivée première du potentiel, les deux premières dérivées du potentiel ou les dérivées d'ordres supérieurs.

Le modèle choisi pour représenter un circuit électronique ne constitue en général pas une caractéristique du système de simulation. En revanche, le choix d'une méthode de résolution du modèle est caractéristique d'un système de simulation et définit ses performances et capacités.

Les systèmes de simulation de circuits électroniques sont en général classés en trois générations définies chacune par la méthode utilisée pour résoudre le système d'équations différentielles représentatif dudit circuit électronique. La première génération correspond aux premiers systèmes de simulation qui ont été développés dans les années 60. Les systèmes de simulation développés dans les années 70 correspondent à peu près à la deuxième génération. Un premier exemple d'un tel système de simulation est décrit dans l'article "SPICE 2 : a computer program to simulate semiconductor circuits", de L.N. Nagel, Université de Californie Berkeley, Mai 1975.

Dans ce système de simulation, la résolution du système d'équations différentielles représentatif du circuit électronique est réalisée par la méthode de Newton. Cette méthode consiste à calculer le jacobien du système d'équations différentielles, ce qui représente une matrice de pxp éléments pour un circuit électronique de p noeuds, puis à inverser ce jacobien. Le potentiel en chaque noeud du circuit électronique s'obtient ensuite directement au moyen de l'inverse du jacobien.

L'inversion du jacobien représente un volume de calcul important. Il faut noter que ce volume croît comme le carré de la taille du circuit simulé, ce qui limite en pratique l'utilisation de ce système de simulation aux circuits électroniques ne dépassant pas environ 50 transistors, car pour des circuits électroniques plus complexes, le temps de calcul devient prohibitif.

L'article "MOTIS - A MOS timing simulator" de B.R. CHAWLA, H.K. GUMMEL et P. KOZAK, paru dans transactions IEEE, vol. CAS-22, n° 12, pp. 901-910, décembre 1975, décrit un autre système de simulation de deuxième génération qui n'utilise pas la méthode de Newton. L'une des caractéristiques de ce système de simulation consiste à négliger le couplage entre certains noeuds, en particulier les faibles couplages arrière.

Ceci permet de simplifier le système d'équations différentielles modélisant le circuit électronique simulé et donc de diminuer le volume des calculs permettant d'obtenir les potentiels des noeuds. Le fait de négliger certains couplages a toutefois pour inconvénient de diminuer la précision sur les potentiels calculés, qui ne sont connus qu'à 10% près environ, et de restreindre l'utilisation de ce système de simulation aux circuits logiques, c'est-à-dire dire aux circuits ne comportant pas de couplages arrière.

Une seconde caractéristique de ce système de simulation est l'ordonnancement des noeuds qui consiste à classer les noeuds dans l'ordre dans lequel ils reçoivent un signal électrique se propageant dans le circuit électronique simulé, et à calculer les potentiels des noeuds du circuit dans cet ordre. Cet ordonnancement est nécessaire à cause de l'approximation causée par la suppression des faibles couplages.

On connaît enfin un système de simulation, dit de troisième génération, dans lequel le potentiel en chaque noeud est déterminé par un calcul itératif sur chaque équation du système d'équations différentielles. Ce système de simulation est décrit notamment dans les articles "The Waveform Relaxation Method for time-domain analysis of large scale integrated circuits" de E. LELARASME, A.E. RUEHLI, et A. SANGIOVANNI-VINCENTELLI paru dans IEEE Transactions on CAD, Vol. CAD-1, N° 3, Juillet 1982, pp. 131-145 et "RELAX a new circuit simulator for large scale MOS integrated circuits" de E. LELARASME et A. SANGIOVANNI-VINCENTELLI publié à la 19ème Conférence DAC, 1982.

La méthode de résolution utilisée dans ce système de simulation est appelée méthode de relaxation d'onde, en abrégé MRO, par référence aux itérations successives effectuées pour obtenir le potentiel en un noeud du circuit.

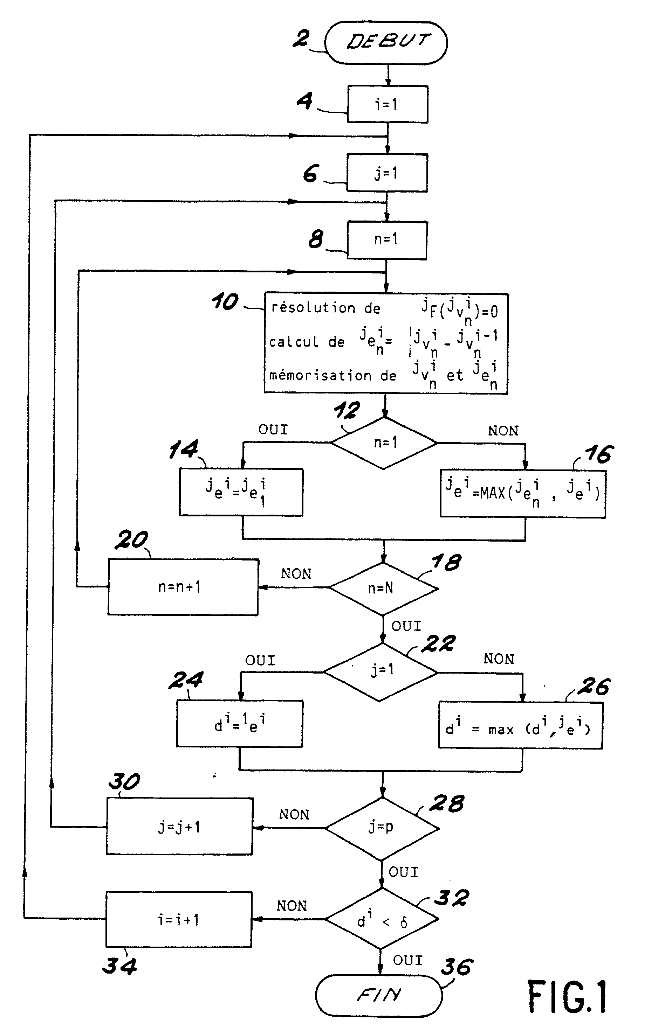

Avant de décrire le fonctionnement de ce système de simulation connu en référence à l'organigramme de la figure 1, on va préciser les notations utilisées dans la suite de la description pour représenter le circuit électronique simulé.

L'état de ce circuit électronique peut être représenté par l'équation différentielle implicite $F(t, V, \dot{V}, \ddot{V},...) = 0$, où t est le temps, $v = ({}^1v, {}^2v,... {}^pv)$ représente les potentiels de chacun des p noeuds du circuit, $\dot{V}$ est la dérivée première de V, $\ddot{V}$ est la dérivée seconde de V,

L'équation $F(t, V, \dot{V}, \ddot{V} ...) = 0$ est un ensemble de p équations différentielles. L'ordre de cette équation est en général compris entre 1 et 6. La résolution de cette équation pour un instant t détermine les potentiels $({}^jv)_1 \leq_j \leq_p$ des noeuds du circuit électronique à cet instant.

Dans la suite de la description, l'indice n, compris entre 1 et N note les instants successifs de calcul de l'état du circuit électronique, l'indice i indique le numéro de l'itération de relaxation lors du calcul du potentiel d'un noeud, et l'indice j, compris entre 1 et p, désigne l'un des noeuds dans un circuit électronique à p noeuds. Avec ces notations, la valeur du potentiel du noeud j à l'instant n obtenue à la ième itération est notée ${}^jv_n^i$ .

L'organigramme représenté sur la figure 1 illustre le traitement effectué par le système de si-simulation MRO connu pour calculer le potentiel en chaque noeud d'un circuit électronique simulé.

Ce traitement comprend une suite d'interrogations (ou propositions) dont le contenu est libellé dans un losange à une entrée et deux sorties, l'une utilisée en cas de réponse affirmative, l'autre en cas de réponse négative et une suite d'opérations, dont le contenu est libellé dans un rectangle à une entrée et une sortie. Chacune des propositions et des opérations est repéré par une référence numérique. L'organigramme comprend en outre une déclaration de début référencée 2 et une déclaration de fin de traitement référencée 36.

Les opérations réalisées sont les suivantes :

- 4 : initialisation de l'indice d'itération i à la valeur 1,

- 6 : initialisation de l'indice de noeud j à la valeur 1,

- 8 : initialisation de l'indice temporel n à la valeur 1,

- 10 : résolution de l'équation ${}^j E({}^j v_n^i) = 0$, calcul de ${}^j e_n^i = \left| {}^j v_n^i - {}^j v_n^{i-1} \right|$, et mémorisation de ${}^j v_n^i$ et de ${}^j e_n^i$,

- 14 : affectation de la valeur ${}^j e_1^i$ à la variable ${}^j e^i$,

- 16 : affectation de la valeur maximale entre ${}^j e_n^i$ et ${}^j e^i$ à la variable ${}^j e^i$,

- 20 : incrémentation de l'indice temporel n,

- 24 : affectation de la valeur ${}^1 e^i$ à la variable $d^i$,

- 26 : affectation de la valeur maximale entre ${}^j e^i$ et $d^i$ à la variable $d^i$,

- 30 : incrémentation de l'indice de noeud j,

- 34 : incrémentation de l'indice d'itération i.

Les interrogations, ou propositions, sont les suivantes :
- 12 : l'indice temporel n est égal à 1,
- 18 : l'indice temporel n est égal à N,
- 22 : l'indice de noeud j est égal à 1,
- 28 : l'indice de noeud j est égal à p,
- 32 : $d^i$ est inférieur à une valeur de seuil déterminée $\delta$.

Le calcul du potentiel en chaque noeud d'un circuit électronique simulé se fait, conformément à l'organigramme de la figure 1, de la manière suivante. Dans un premier temps, les indices d'itération i et de noeud j sont initialisés à 1. Le procédé de résolution consiste alors à calculer, pour chaque instant $T_n$, $1 \leqslant n \leqslant N$, une première valeur du potentiel du premier noeud. Ceci est obtenu par résolution de l'équation différentielle implicite ${}^1 E({}^1 v_n^1) = 0$, déduite de la première composante de l'équation différentielle vectorielle $F(t, V, \dot{V}, \ddot{V}, ...) = 0$, pour chaque instant $T_n$ (opération 10). Cette opération est ensuite répétée pour chacun des p noeuds. A la fin de la première itération, on a donc mémorisé pxN valeurs de potentiel.

Ces valeurs constituent une première approximation du potentiel de chaque noeud à chaque instant. Par itérations successives, ces pxN valeurs de potentiel vont être affinées.

Cette itération se poursuit jusqu'à la convergence de chacune des pxN suites $({}^j v_n^1, {}^j v_n^2, {}^j v_n^3, ...)$, où $1 \leqslant j \leqslant p$ et $1 \leqslant n \leqslant N$. Pour déterminer s'il y a convergence, on calcule pour chaque noeud j et pour chaque instant $T_n$, un terme d'erreur ${}^j e_n^i$ égal

$$\text{à } \left| {}^j v_n^i - {}^j v_n^{i-1} \right| \text{ (opération 10).}$$

Cette méthode de calcul du potentiel en chaque noeud et à chaque instant d'un circuit électronique simulé appelle au moins deux remarques. Premièrement, la valeur réelle du potentiel en un noeud quelconque à un instant quelconque n'est connue qu'à la fin du traitement. Deuxièmement, cette méthode nécessite de mémoriser au moins pxN valeurs de potentiel constituant le résultat d'une itération, mais aussi les pxN valeurs de potentiel calculées lors de l'itération précédente, afin de vérifier si chacune des pxN suites de potentiels convergent. Cette méthode de traitement requiert donc une mémoire de données contenant au moins 2xpxN valeurs de potentiel. Il faut remarquer également que si une seule suite ne converge pas, une nouvelle itération est effectuée pour chacune des pxN suites, ce qui peut conduire à recalculer inutilement des valeurs de potentiel dont les suites associées sont déjà convergentes.

Le nombre d'instants N où le potentiel est calculé pouvant être supérieur à 1000, on conçoit que cette méthode de résolution nécessite une mémoire très importante, qui est de l'ordre de 1 Mo pour un circuit électronique comprenant environ 50 transistors.

Enfin, l'article PROCEEDINGS OF THE IEEE, vol. 69, n° 10, Octobre 1981, pp. 1264-1280 passe en revue les différents systèmes de simulation dits de troisième génération et effectue un classement des méthodes mises en oeuvre dans ces Systèmes.

Trois types de décomposition d'un système d'équations différentielles sont évoqués, à savoir la décomposition des systèmes linéaires, dont la résolution consiste à inverser une matrice, la décomposition des systèmes non linéaires et la décomposition des systèmes dynamiques, dont la résolution utilise la méthode de relaxation d'ondes.

L'invention a pour objet un système de simulation permettant de simuler des circuits électroniques notablement plus complexes que dans l'art antérieur et ceci de manière plus rapide.

A cette fin, la présente invention a pour objet un système de simulation comprenant un processeur, une mémoire morte contenant des instructions destinées au processeur, une mémoire vive comprenant une première zone contenant des données représentant le circuit à simuler et une deuxième zone de calcul, un circuit d'entrées-sorties, un bus de données et un bus d'adresses tous deux interconnectant le processeur, les mémoires et le circuit entrées-sorties, un moyen de visualisation relié au circuit entrées-sorties par un bus bidirectionnel, ce système de simulation étant caractérisé par le fait que le processeur, les instructions contenues dans la mémoire morte et la deuxième zone de calcul de la mémoire vive sont aptes à :

a) calculer le potentiel de tous les noeuds du réseau à un instant déterminé $T_n$, avec n entier compris entre 1 et N, en résolvant pour chaque noeud une équation implicite relative au potentiel de ce noeud, et en mettant en oeuvre une suite d' itérations,

b) calculer pour chaque noeud, la différence entre le potentiel calculé pour ce noeud après une itération et le potentiel de ce même noeud obtenu après l' itération précédente,

c) comparer cette différence avec un seuil prédéterminé,

d) mettre en oeuvre une nouvelle itération a) à c), si ladite différence excède ledit seuil, sinon :

e) calculer par les opérations précédentes a) à d) le potentiel de tous les noeuds à l' instant suivant $T_n$ + 1 défini par l'entier (n + 1) jusqu'à ce que cet entier atteigne la valeur N,

f) faire afficher sur le moyen de visualisation les différentes valeurs des potentiels ainsi calculés pour tous les noeuds du circuit.

Le procédé mis en oeuvre dans le système de l'invention permet donc de calculer le potentiel de tous les noeuds à un instant donné, puis le potentiel de tous les noeuds à l'instant suivant, etc... De cette manière, il n'est plus nécessaire de mémoriser toutes les valeurs de potentiel calculées comme dans la méthode MRO.

De plus, les potentiels des noeuds étant calculés simultanément à chaque instant T, il est possible d'utiliser un pas temporel Δt variable dans le système de l'invention. Ceci n'est pas possible avec les systèmes de type MRO.

Ceci a pour résultat un gain d'espace mémoire très important qui permet notamment de simuler des circuits électroniques ayant une complexité de 1000 transistors ou plus. Ceci permet également de délivrer des valeurs de potentiel sans attendre la fin de la simulation, puisque le calcul des valeurs de potentiel correspondant aux x premiers instants, $1 \leq x \leq N$, est terminé après une durée $\frac{x}{N}$ T, où T est la durée totale de la simulation.

En règle générale, la valeur du potentiel s'obtient en quelques itérations de relaxation. Cependant, pour certains circuits particuliers, et notamment les circuits bipolaires, le nombre d' itérations de relaxation nécessaire pour obtenir le potentiel d'un noeud peut être très important.

Il est alors avantageux, pour accélérer la convergence de la suite $^jv_n$, $^jv^2_n$, . . ., $^jv^i_n$, où i est l'indice d'itération, d'utiliser comme valeur de départ d'une itération une combinaison linéaire des valeurs obtenues au cours des deux précédentes itérations au lieu de prendre comme valeur de départ la valeur obtenue à la précédente itération. Autrement dit, pour l'itération io, on prend comme valeur de départ $\lambda.^jv^i_n o^{-1} + (1-\lambda).^jv^i_n o^{-2}$ au lieu de $^jv^i_n o^{-1}$.

La valeur du coefficient $\lambda$ de la combinaison linéaire dépend de la suite $^jv^1_n$, $^jv^2_n$, . . ., $^jv_n{}^io^{-1}$. Si cette suite est monotone, c'est-à-dire croissante ou décroissante, $\lambda$ est choisi supérieur à 1 ce qui permet d'accélérer la convergence par anticipation de la variation de la suite (sur-relaxation). Si la suite est oscillante, $\lambda$ est choisi inférieur à 1 (sous-relaxation) ce qui permet d'accélérer la convergence par lissage de l'oscillation de la suite.

Pour certains cas particuliers, l'utilisation de la sur-relaxation ou de la sous-relaxation permet de réduire par 3 le nombre d'itérations de relaxation nécessaires et donc le temps de calcul.

Pour résoudre l'équation implicite relative au potentiel d'un noeud, le processeur utilise de manière préférée la méthode du point fixe suivi d'une sécante.

Cette méthode connue évite le recours toute dérivation de l'équation implicite décrivant l'état du circuit électronique simulé. Par rapport à la méthode de Newton, utilisée généralement dans les systèmes de simulation connus, qui calcule la dérivée de l'équation implicite, le gain en temps de calcul est important.

De manière avantageuse, le système de simulation se caractérise en ce que pour chaque instant fixé $T_n$, où 1 n N, le processeur déduit une valeur estimée, ou prédicteur, de la valeur du potentiel de chaque noeud à l'instant suivant $T_{n+1}$ à partir du potentiel calculé à l'instant $T_n$, ledit prédicteur étant utilisé pour initialiser le calcul itératif du potentiel dudit noeud à l'instant suivant $T_{n+1}$

Cette prédiction de la valeur du potentiel en chaque noeud à l'instant suivant est intéressante car, d'une part, elle est pratiquement gratuite en temps des calculs en ce sens qu'il n'y a pas d'équation différentielle à résoudre pour obtenir ce prédicteur et, d'autre part, elle constitue une initialisation du calcul itératif du potentiel de chaque noeud à l'instant suivant et permet donc de réduire le nombre d'itérations d'une unité par rapport à l'art antérieur décrit en référence à la figure 1. La valeur du potentiel de chaque noeud s'obtient ainsi, en moyenne, en deux itérations au lieu de trois dans l'art antérieur ; le gain en temps de calcul est donc de l'ordre de 33%.

De manière préférée, le système de simulation se caractérise en ce que les noeuds du circuit électronique simulé sont ordonnés suivant les dates auxquelles ils reçoivent un signal se propageant dans ledit circuit et émis par un noeud prédéterminé, le processeur calculant le potentiel des noeuds suivant cet ordre.

L'ordonnancement des noeuds a pour effet de rendre plus rapide la convergence des valeurs de potentiel calculées par itération. Cet ordonnancement reste une option dans le système de simulation de l'invention. Il est important de noter que les valeurs de potentiel calculées sont identiques, avec le système de simulation de l'invention, que les noeuds soient ordonnés ou qu'ils ne le soient pas.

Les caractéristiques et avantages de l'invention ressortiront mieux de la description qui va suivre, donnée à titre illustratif mais non limitatif, en référence aux dessins annexés, sur lesquels :
- la figure 1, déjà décrite, représente l'organigramme correspondant à la méthode de résolution connue dite de relaxation d'onde,
- la figure 2 représente l'organigramme correspondant à la méthode de résolution de l'invention,
- les figures 3a et 3b représentent des graphiques dans l'espace des incides i, j, n illustrant l'ordre dans lequel sont effectués les calculs des potentiels des noeuds respectivement selon la méthode de relaxation d'onde décrite en référence à la figure 1 et la méthode de l'invention décrite en référence à la figure 2,
- la figure 4 représente schématiquement un système de simulation conforme à l'invention,
- la figure 5a représente schématiquement un circuit numérique simulé par le système de l'invention,
- la figure 5b représente en détail un additionneur du circuit de la figure 5a,
- la figure 5c est un chronogramme des signaux de sortie de la figure 5a calculés au moyen du système de simulation de l'invention,
- la figure 6 représente schématiquement un convertisseur analogique-numérique simulé par le système de l'invention,
- la figure 7a représente schématiquement un circuit à capacités commutées simulé par le système de l'invention,
- la figure 7b représente la réponse impulsionnelle du circuit de la figure 7a calculée par le système de simulation de l'invention.
- la figure 8 est un graphique comparant, pour des systèmes de simulation connus, et pour le système de simulation de l'invention, le temps de calcul en fonction du nombre de transistors du circuit électronique simulé.

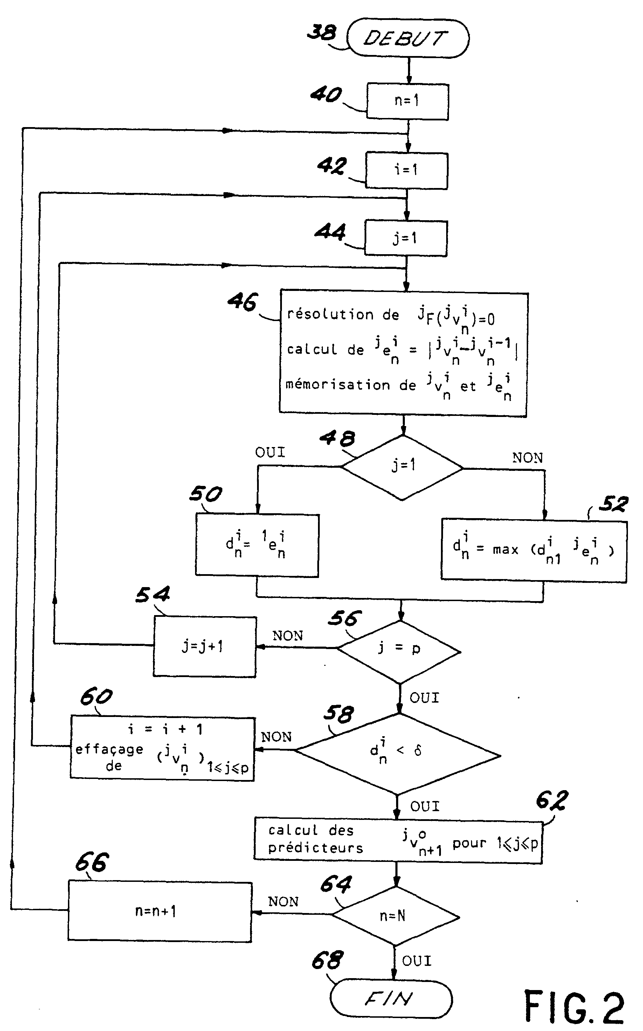

On va maintenant décrire la méthode de résolution utilisée dans le système de simulation de l'invention en référence à l'organigramme de la figure 2. Cet organigramme comprend des rectangles et des losanges dont la signification est identique à ceux de la figure 1.

Le traitement comprend les propositions ou interrogations suivantes :
- 48 : l'indice de noeud j est égal à 1,
- 56 : l'indice de noeud j est égal à p,
- 58 : la variable $d_n^j$ est inférieure à un seuil déterminé,
- 64 : l'indice temporel n est égal à N.

Le traitement comprend également les opérations suivantes :

- 40 : initialisation de l'indice temporel n à 1,

- 42 : initialisation de l'indice d'itération i à 1,

- 44 : initialisation de l'indice de noeud j à 1,

- 46 : . résolution de $^{j}E(^{j}v_n^{i})=0$,

    . calcul de $^{j}e_n^{i} = \left| ^{j}v_n^{i} - ^{j}v_n^{i-1} \right|$

    . mémorisation de $^{j}v_n^{i}$ et $^{j}e_n^{i}$,

- 50 : affectation de la valeur $^{1}e_n^{i}$ à la variable $d_n^{i}$,

- 52 : affectation de la plus grande des valeurs entre $^{j}e_n^{i}$ et $d_n^{i}$ à la variable $d_n^{i}$,

- 54 : incrémentation de l'indice de noeud j,

- 60 : . incrémentation de l'indice d'itération i,

    . Effaçage de $^{j}v_n^{i}$ pour $1 \leqslant j \leqslant p$,

- 62 : évaluation des prédicteurs $^{j}v_{n+1}^{0}$ pour $1 \leqslant j \leqslant p$,

- 66 : incrémentation de l'indice temporel n.

L'organigramme comprend en outre deux opérations de déclaration référencées 38 et 68 et correspondant respectivement au début et à la fin du traitement.

On va maintenant décrire en détail le traitement effectué par le système de simulation de l'invention. Ce traitement consiste, pour le noeud j, où 1 j p, à résoudre une équation implicite liant le potentiel de ce noeud au potentiel des autres noeuds du graphe représentant le circuit électronique simulé.

L'équation différentielle utilisée pour décrire l'évolution du potentiel d'un noeud du graphe n'est pas liée au système de simulation de l'invention. De nombreux modèles de représentation peuvent être utilisés tels que ceux du trapèze ou de GEAR déjà cités plus haut. A titre d'exemple illustratif, on va décrire le traitement effectué par le système de simulation de l'invention en utilisant le modèle d'intégration inverse d'Euler du premier ordre qui peut être représenté par l'équation $\dot{V} = F(V,t)$, dans laquelle $\dot{V}$ est un vecteur dont les composantes sont les potentiels de chaque noeud du graphe et $\dot{V}$ est un vecteur dont les composantes sont les dérivées premières desdits potentiels.

De manière classique, on associe au graphe représentant le circuit électronique à simuler une suite ordonnée des noeuds de ce graphe. Ces noeuds sont classés dans l'ordre dans lequel ils reçoivent un signal se propageant dans le graphe et émis à partir d'un noeud particulier. Cette méthode, dite d'ordonnancement des noeuds, permet de simplifier les calculs de résolution de l'équation différentielle décrivant le graphe, sans limiter la précision de ces calculs. On suppose que l'indice j classe les noeuds dans cet ordre. Avec cet ordre et en remplaçant la dérivée continue $\dot{V}$ par un accroissement discret, l'équation d'intégration inverse d'Euler peut être remplacée par les j équations :

$$^{j}v_n^{i} = {}^{j}v_{n-1}^{i} + \Delta t \cdot {}^{j}F(^{1}v_n^{i}, \ldots, {}^{j}v_n^{i}, {}^{j+1}v_n^{i-1}, \ldots, {}^{p}v_n^{i-1})$$

où $^{j}F$ note la $j^{\text{ième}}$ composante de F, $1 \leqslant j \leqslant p$, et $\Delta t$ est la durée entre les instants $T_{n-1}$ et $T_n$.

Le traitement effectué par le système de simulation de l'invention consiste, pour un instant $T_n$ fixé, où $1 \leqslant n \leqslant N$, à calculer une première valeur (i = 1) du potentiel en chaque noeud j($1 \leqslant j \leqslant p$) du graphe représentant le circuit électronique simulé. Cette première valeur est calculée pour chacun des noeuds j à l'aide de l'expression précédente.

On note que lors du calcul de la première valeur d'un potentiel (i = 1), le calcul de la valeur du potentiel du noeud de rang j fait intervenir les valeurs des potentiels des noeuds inférieurs à j calculées au cours de la même itération et les valeurs des potentiels des noeuds d'indice supérieur à j obtenues au cours de l'itération précédente.

Or, lors de la première itération, pour le noeud j, les potentiels des noeuds d'indice supérieur à j ne sont pas calculés. On utilise alors pour ces noeuds, une valeur de potentiel calculée d'une manière différente qui sera précisée dans la suite de la description. Les potentiels de ces noeuds sont repérés par un indice d'itération égal à 0.

Lorsqu'une première valeur de potentiel est obtenue pour chacun des noeuds du graphe par une première itération, une ou plusieurs autres itérations peuvent être réalisées. Ces itérations sont poursuivies jusqu'à ce que chacune des p suites $({}^{j}v_n^i)_{i \geq 1}$ converge. La convergence est déclarée atteinte lorsque la différence entre les deux derniers termes de chacune des p suites est inférieure à un seuil déterminé $\delta$.

Dans l'organigramme de la figure 2, la convergence est mise en oeuvre par l'opération 46 dans laquelle on calcule le terme d'erreur ${}^{j}e_n^i$ égal à la différence entre les valeurs de potentiel du noeud j, à l'instant $T_n$, données par les deux dernières itérations ; elle est aussi mise en oeuvre dans les opérations 50 et 52 qui déterminent l'erreur maximale $d_n^i$ dans la suite $({}^{j}e_n^i)_{1 \leq j \leq n}$, et dans la proposition 56 qui compare cette erreur $d_n^i$ au seuil déterminé $\delta$.

Si la proposition 58 est vraie, les p valeurs obtenues au cours de la dernière itération constituent les valeurs des potentiels des p noeuds du graphe à l'instant $T_n$. Si la proposition 58 est fausse, une nouvelle itération est commandée par l'opération 60.

Il faut noter que pour chaque instant $T_n$, le nombre de valeurs de potentiel mémorisé à chaque itération i est égal à p. Pour vérifier la convergence des p valeurs de potentiel à un instant donné, il suffit de conserver en mémoire les valeurs de potentiel à des deux dernières itérations, soit 2xp valeurs.

Comme on le verra dans la suite de la description, les valeurs de potentiel obtenues à un instant $T_n$ sont utilisées pour initialiser le calcul des potentiels l'instant suivant $T_{n+1}$. Cette étape d'initialisation effectuée, les p valeurs de potentiel calculées à l'instant $T_n$ ne sont plus utilisées par le système de simulation. Ces valeurs peuvent donc être avantageusement stockées dans une mémoire secondaire du système de simulation et être effacées de la mémoire centrale (opération 60).

Il apparaît donc qu'à chaque instant le nombre de valeurs de potentiel mémorisées dans la mémoire centrale du système de simulation n'excède pas 2xp termes. Ceci est à comparer aux 2xpxN termes qui devaient être mémorisés dans le système de simulation fondé sur la méthode MRO connue.

Cette nécessité d'une mémoire de taille importante dans le système selon l'art antérieur a pour conséquence de limiter ses performances à des circuits électroniques dont le graphe est limité à une cinquantaine de transistors. Cette contrainte n'existe plus avec le système de simulation de l'invention dont les performances, du point de vue de la mémoire centrale requise, permettent le traitement de circuits électroniques représentés par un graphe comportant de l'ordre de un millier de transistors.

Le système de simulation de l'invention peut également, selon une variante préférée de réalisation, accroître ses performances par la diminution du temps de calcul nécessaire pour déterminer la valeur des potentiels des noeuds du graphe. Cette variante préférée de réalisation correspond à l'opération 62 de l'organigramme de la figure 2. Cette opération consiste à estimer, ou prédire, une valeur du potentiel de chacun des p noeuds du graphe à l'instant $T_{n+1}$ en fonction des valeurs calculées à l'instant précédent $T_n$. Les valeurs estimées, ou prédicteurs, produites par cette opération sont notées ${}^{j}v_{n+1}^0$.

Cette opération 62 est intéressante car les prédicteurs s'obtiennent par résolution d'une simple équation algébrique, ce qui est pratiquement gratuit en temps de calcul. Pour chaque noeud j, ce prédicteur peut être calculé par l'expression :

$$ {}^{j}v_{n+1}^0 = {}^{j}v_n^i + \Delta t \cdot {}^{j}F({}^{1}v_n^i, \ldots, {}^{j}v_n^i, {}^{j+1}v_n^{i-1}, \ldots, {}^{p}v_n^{i-1}). $$

L'opération 62 est importante car, en initialisant les valeurs de potentiel pour l'instant $T_{n+1}$, elle permet de supprimer une itération. Le nombre d'itérations nécessaires pour calculer la valeur des potentiels des noeuds à un instant donné est ainsi ramené, en moyenne, à 2 au lieu de 3 dans les systèmes de simulation connus. La diminution en temps de calcul n'est donc pas négligeable.

On peut résumer les caractéristiques du traitement connu correspondant à l'organigramme de la figure 1 et du traitement selon l'invention correspondant à l'organigramme de la figure 2 à l'aide d'un graphique représentant les calculs effectués.

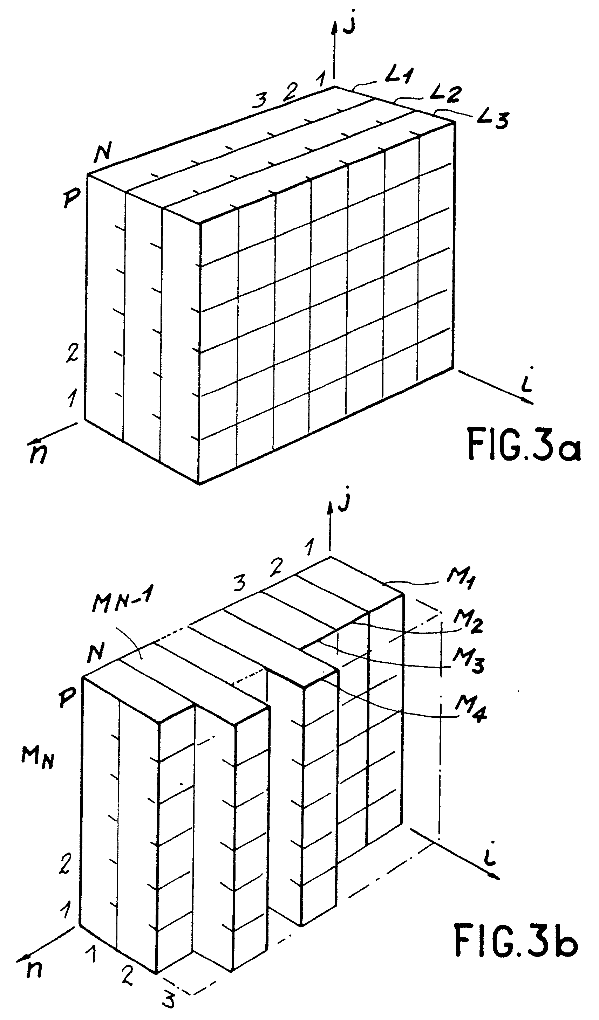

Sur la figure 3a, on a représenté le cas correspondant au traitement connu de la figure 1. Ce graphique comporte un ensemble de rectangles parallèles repérés par un système orthonormé de coordonnées dont les axes représentent respectivement l'indice d'itération i, l'indice de noeud j et l'indice temporel n.

Les rectangles sont parallèles au plan (j, n). La longueur du côté de chaque rectangle est égale à p suivant l'axe j et à N suivant l'axe n. Le rectangle $L_1$ représente les pxN valeurs de potentiel calculées lors de la première itération (i = 1). De même, les rectangles $L_2$ et $L_3$ correspondent respectivement aux itérations d'ordre 2 et d'ordre 3.

Suivant la représentation adoptée, les calculs se font rectangle par rectangle. Ainsi, si pour une seule valeur de potentiel, il est nécessaire de procéder à une quatrième itération, cette itération devra en fait être réalisée pour pxN valeurs. Rappelons par ailleurs que toutes les valeurs de potentiel calculées doivent être contenues simultanément dans la mémoire centrale du système de simulation.

La figure 3b illustre les caractéristiques du traitement opéré suivant l'invention. Les valeurs de potentiel calculées sont ici également représentées par des rectangles $M_1$, $M_2$,...,$M_N$. Ces rectangles sont parallèles au plan (i,p). La longueur de leurs côtés suivant l'axe i n'est pas fixe et est en général égale à 2 ou 3 ; la longueur de leurs côtés suivant l'axe j est égale à p. La taille de chacun des rectangles correspond au volume des calculs effectués à chaque instant $T_n$, $1 \leqslant n \leqslant N$.

La comparaison des figures 3a et 3b montre que le traitement effectué suivant l'invention est plus souple, car le nombre d'itérations n'est pas fixe mais varie au contraire pour chaque valeur de l'indice temporel n. D'autre part, le nombre de valeurs mémorisées à chaque instant dans la mémoire centrale du système de simulation de l'invention est égal au plus à 2p. Enfin, à la différence du traitement correspondant à la figure 3a, dans lequel les valeurs de potentiel pour chaque instant n compris entre 1 et N ne sont disponibles qu'à la fin des calculs, le traitement suivant l'invention permet de délivrer régulièrement, pendant les calculs, les valeurs des potentiels de chaque noeud au cours des instants successifs.

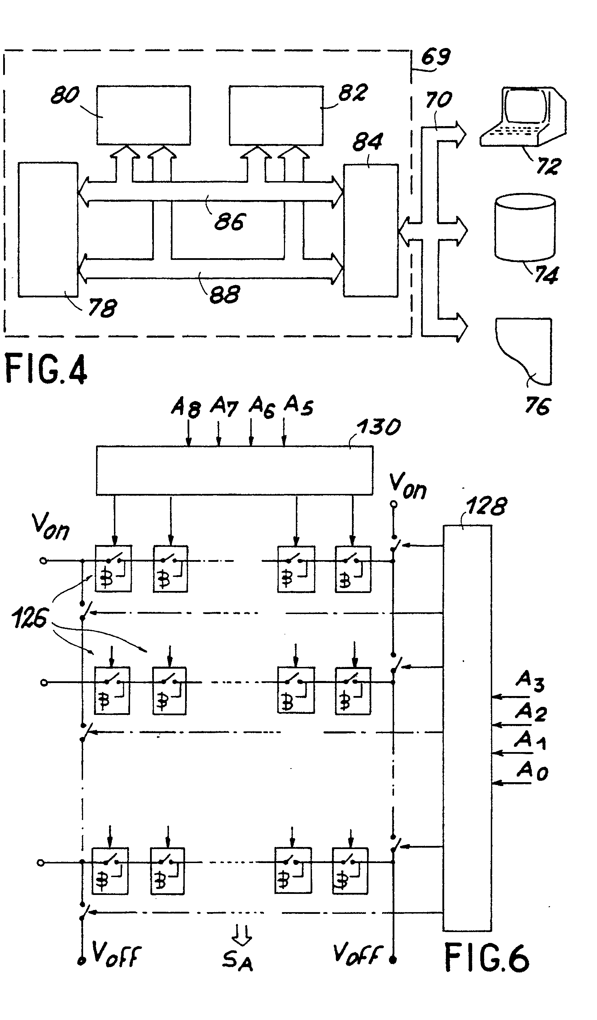

On va maintenant décrire en référence à la figure 4 un mode de réalisation du système de simulation de l'invention. Ce système comprend un moyen de calcul 69 relié par un bus bidirectionnel 70, à un moyen de commande et de visualisation 72, un moyen de mémorisation 74 et un moyen d'impression 76. De manière classique, le bus 70 comprend des voies de données, des voies d'adresse et des voies de commande.

Le moyen de calcul 69 comprend un processeur 78, une mémoire morte 80, une mémoire vive 82 et uncircuit d'entrée-sortie 84. Ces différents éléments sont reliés entre eux par un bus de données 86 et un bus d'adresse 88. Le circuit d'entrée-sortie 84 est par ailleurs relié au bus 70.

La mémoire vive 82 comprend une première zone contenant des données pour représenter le circuit électronique simulé, ces données étant entrées au moyen d'un programme contenu dans la mémoire morte 80. La mémoire vive 82 comprend en outre une zone de calcul utilisée par le processeur 78 pour l'exécution du traitement correspondant à l'organigramme de la figure 2. Le traitement correspondant à cet organigramme est représenté sous forme d'une suite d'instructions contenues dans la mémoire morte 80 exécutable par ledit processeur 78.

Outre les avantages, déjà soulignés, du système de simulation quant à la faible mémoire nécessaire, à la complexité des circuits électroniques simulables et la vitesse de calcul, le système de l'invention présente également la caractéristique remarquable d'être apte à simuler tous les types de circuits électroniques, ce qui n'est pas le cas des systèmes de simulation connus.

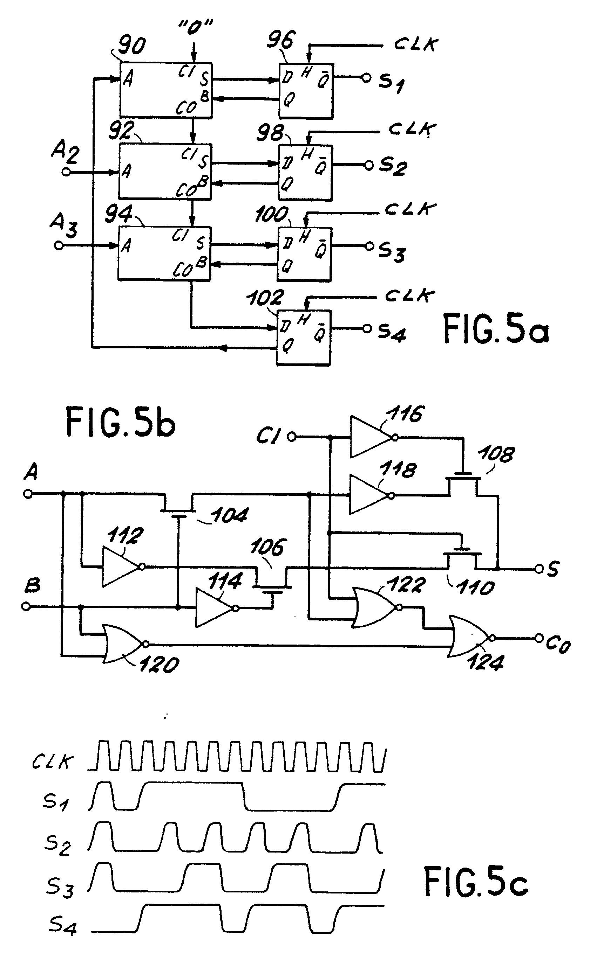

On va décrire successivement, en référence aux figures 5 à 7, un circuit numérique, un convertisseur analogique-numérique et un circuit à capacités commutées simulés par le système de l'invention.

On a représenté sur la figure 5a un circuit numérique simulé par le système de simulation de l'invention. Il s'agit d'un additionneur à boucle comprenant trois additionneurs élémentaires référencés 90, 92, 94 et quatre bascules de type D référencées 96, 98, 100, 102.

Chaque additionneur comprend une entrée A, une entrée B, une entrée de retenue CI, une sortie S et une sortie de retenue CO. A chaque additionneur est associée une bascule dont l'entrée de données B est reliée à la sortie S et la sortie non inverseuse Q à l'entrée B. Le circuit comprend également les liaisons suivantes : sortie CO de l'additionneur 90 reliée à l'entrée CI de l'additionneur 92, sortie CO de l'additionneur 92 reliée à l'entrée CI de l'additionneur 94, sortie CO de l'additionneur 94 reliée à l'entrée de données D de la bascule 102. De plus, l'entrée CI de l'additionneur 90 reçoit un signal logique au niveau bas. En outre, on a rebouclé le circuit en reliant la sortie non inverseuse Q de la bascule 102 à l'entrée A de l'additionneur 90.

Le circuit représenté sur la figure 5a comprend deux entrées $A_2$ et $A_3$ reliées respectivement aux entrées A des additionneurs 92 et 94, et quatre sorties $S_1$, $S_2$, $S_3$ et $S_4$ reliées respectivement aux sorties inverseuses $\overline{Q}$ des bascules 96, 98, 100 et à la sortie non inverseuse Q de la bascule 102.

On a représenté sur la figure 5b un mode de réalisation de chacun des additionneurs 90, 92 et 94. Il comprend quatre transistors MOS 104, 106, 108, 110, quatre inverseurs 112, 114, 116 et 118 et trois portes NON-OU 120, 122 et 124.

L'entrée A de l'additionneur est reliée à l'entrée de l'inverseur 112, à une entrée de la porte 120, à l'entrée de l'inverseur 118 par le transistor 104 et à une entrée de la porte 122 par ce même transistor 104. L'entrée B de l'additionneur est reliée à l'autre entrée de la porte 120, à l'entrée de l'inverseur 114 et à la base du transistor 104. La sortie de l'inverseur 112 est reliée par le transistor 106, commandé par la sortie de l'inverseur 114, et par le transistor 110 à la sortie S de l'additionneur. L'entrée de retenue CI de l'additionneur est reliée à l'entrée de l'inverseur 116, à la base du transistor 110 et à l'autre entrée de la porte 122. La sortie de l'inverseur 116 commande la base du transistor 108 qui relie la sortie de l'inverseur 118 à la sortie S de l'additionneur. Enfin, les entrées de la porte 124 sont reliées aux sorties des portes 120 et 122, et sa sortie est reliée à la sortie de retenue CO.

Le circuit additionneur à boucle représenté sur la figure 5a, et dont les additionneurs 90, 92 et 94 sont illustrés par la figure 5b, est un circuit numérique comportant environ 150 transistors MOS. Ce circuit peut difficilement être simulé sur un système de simulation reposant sur la méthode de relaxation d'onde à cause de l'importante mémoire de données requise. Cette contrainte disparaît avec le système de simulation de l'invention.

La figure 5c représente les signaux de sortie $S_1$, $S_2$, $S_3$ et $S_4$ du circuit de la figure 5a en fonction du signal d'horloge CLK appliqué sur les bascules. Le chronogramme da la figure 5c correspond à une fréquence d'horloge de 50 MHz, il représente le cas où les entrées $A_2$ et $A_3$ de l'additionneur à boucle sont maintenues au niveau logique haut. On note la précision de la simulation de la valeur des signaux calculée par le système de simulation qui parvient à reproduire les imperfections dans le front de montée des signaux dès lors que la fréquence du signal d'horloge est élevée.

A titre d'illustration des performances du système de simulation de l'invention, le circuit additionneur de la figure 5a a été simulé par un système de simulation utilisant la méthode de Newton évoquée plus haut. Le rapport des temps de traitement pour une simulation identique effectuée sur un même ordinateur (VAX/VMS 780 de Digital Equipment) est de 10 en faveur du système de simulation de l'invention.

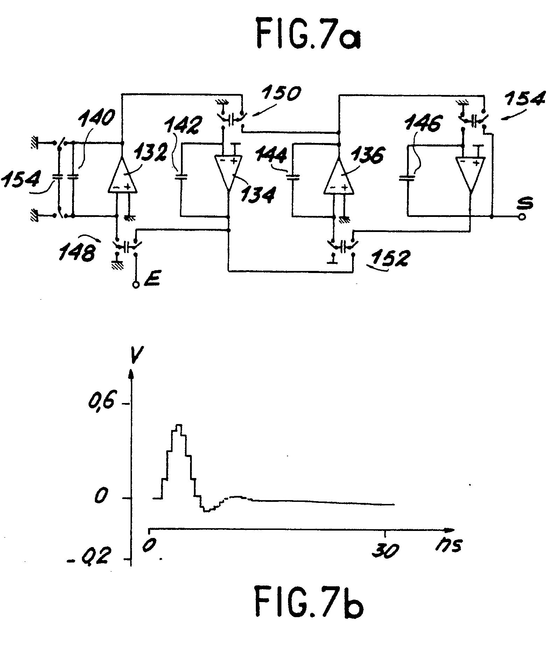

On a représenté sur la figure 6 un convertisseur analogique-numérique à 8 bits. Il s'agit là d'un circuit qui est en général délicat à simuler car, comme tout circuit analogique, il comporte des couplages forts entre certains noeuds. De plus, le circuit représenté sur la figure est particulièrement complexe car il comporte 256 cellules contenant chacune 6 transistors, soit une complexité de l'ordre de 1600 transistors MOS. La structure d'un tel convertisseur est classique et est décrite notamment dans l'article "THPM 14.6 : A 60 ns Glitch-Free NMOS DAC" de V. SHEN et D. HODGES présenté en 1983 à la Conférence IEEE International Solid-State Circuits.

Ce convertisseur comprend 256 cellules identiques, référencées 126 organisées en une matrice de 16 lignes et de 16 colonnes. Des interrupteurs, constitués de transistors MOS, sont prévus pour relier chaque cellule soit à une tension $V_{on}$, soit à une tension $V_{off}$. Dans le premier cas, la cellule débite, dans le second elle ne débite pas. Le courant de sortie du convertisseur est constitué par la superposition des courants délivrés par les cellules débitrices.

Les 8 bits du signal numérique reçu sont divisés en un premier groupe de 4 bits utilisés pour l'adressage d'une ligne de la matrice et en un deuxième groupe de 4 bits utilisés pour l'adressage d'une colonne de la matrice. La combinaison de ces deux signaux d'adressage permet de désigner l'une des cellules de la matrice. Des moyens de commande 128 et 130 recevant chacun l'un des groupes de 4 bits actionnent alors des interrupteurs pour rendre débitrices toutes les cellules dont l'indice de ligne est identique à l'indice de ligne de la cellule désignée mais dont la colonne est supérieure, et toutes les cellules dont l'indice de ligne est supérieur à l'indice de ligne de la cellule désignée.

Le système de simulation de l'invention a permis de simuler ce convertisseur analogique-numérique en rendant possible l'analyse du temps d'établissement du courant de sortie, lorsque le signal d'entrée passe de l'amplitude maximale à un signal nul, avec une précision de 0,1% en prenant en compte les effets parasites dus aux contraintes d'incrémentation.

On a représenté sur la figure 7a un troisième type de circuit électronique simulé par le système de simulation de l'invention. Il s'agit d'un filtre passe-bas de Butterworth du 4ème ordre. La principale difficulté de simulation d'un tel circuit provient de la présence de capacités commutées.

Le filtre représenté sur la figure 7a a une structure classique. Il comporte quatre amplificateurs différentiels 132, 134, 136 et 138 munis chacun d'une chaîne de contre-réaction constituée de condensateurs portant respectivement les références 140, 142, 144 et 146.

Le filtre comporte également des capacités commutées disposées comme suit : une capacité commutée 148 entre l'entrée E du filtre et l'entrée inverseuse de l'amplificateur 132, une capacité commutée 150 entre la sortie de l'amplificateur 132 et l'entrée inverseuse de l'amplificateur 134, une capacité commutée 152 entre la sortie de l'amplificateur 134 et l'entrée inverseuse de l'amplificateur 136, une capacité commutée 154 entre la sortie de l'amplificateur 136 et l'entrée de l'amplificateur inverseur 138, et une capacité commutée 156 en parallèle avec le condensateur 140. Le filtre comporte enfin des liaisons pour relier la sortie d'un amplificateur à la capacité commutée associée à l'amplificateur précédent, tel que l'amplificateur 134 et la capacité commutée 148.

La simulation d'un tel circuit requiert le calcul de la valeur de potentiel des noeuds du graphe associés à ce circuit pendant un nombre d'instants successifs très important. Les calculs effectués par le système de simulation sont donc volumineux. Pour diminuer le volume du traitement, sans nuire à la précision du calcul des potentiels des noeuds, on utilise des macromodèles pour les amplificateurs opérationnels et pour les commutateurs MOS. Grâce à la méthode de calcul par bloc pour les noeuds couplés linéairement, et l'utilisation de l'équation de conservation de la charge dans les condensateurs flottants, la réponse impulsionnelle de ce filtre a été calculée de manière très précise. Cette réponse impulsionnelle a été obtenue en 12 mn de temps processeur sur un ordinateur VAX/VMS 780 de Digital Equipment. La fonction de transfert du filtre passebas du 4ème ordre a également été calculée en utilisant un programme de transformée de Fourier rapide. Celle-ci permet d'étudier les phénomènes fortement non linéaires des amplificateurs opérationnels tels que la limitation du temps de réponse et le gain fini.

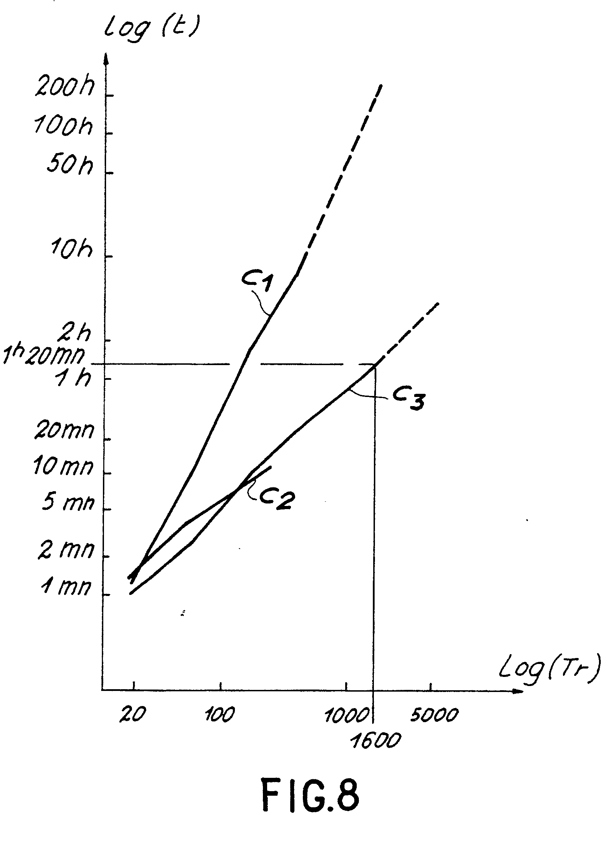

On terminera cette description en comparant les performances du système de simulation de l'invention avec deux systèmes de simulation connus, l'un mettant en oeuvre la méthode de résolution de Newton, et l'autre mettant en oeuvre la méthode de relaxation d'onde. Cette comparaison est illustrée par le graphique de la figure 8 sur lequel est représentée, pour chacun de ces systèmes de simulation, une courbe indiquant le logarithme du temps de calcul t (temps de calcul CPU) en fonction du logarithme du nombre de transistors Tr du circuit électronique simulé, ce nombre de transistors étant un indice représentatif de la complexité d'un circuit électronique simulé.

Les temps de calcul indiqués correspondent à une simulation effectuée sur un ordinateur de type VAX/VMS 780 de Digital Equipment. Bien entendu, ce temps de calcul varie en fonction du matériel informatique utilisé. Il ne faut donc retenir dans ce graphique que le rapport des temps de calcul entre les simulations effectuées par deux systèmes différents.

Les courbes $C_1$, $C_2$ et $C_3$ correspondent respectivement à une simulation effectuée selon la méthode de Newton, selon la méthode de relaxation d'onde et selon la méthode de l'invention. Les courbes $C_2$ et $C_3$ ont une pente sensiblement égale, le temps de calcul croissant ici linéairement avec la complexité du circuit électronique simulé. En revanche, pour la méthode de résolution de Newton qui consiste à inverser le jacobien du système d'équations différentielles représentant le circuit électronique simulé, le volume des calculs augmente comme le carré de la complexité du circuit simulé. La pente de la courbe $C_1$ est ainsi double des pentes des courbes $C_2$ et $C_3$, ce qui conduit à des temps de calcul prohibitifs pour des circuits électroniques simulés comportant plus de 300 transistors environ.

La méthode de relaxation d'onde représentée par la courbe $C_2$ a des performances, du point de vue temps de calcul, comparable à la méthode de l'invention représentée par la courbe $C_3$ pour les circuits électroniques dont la complexité est inférieure à 300 transistors environ. Cette complexité de circuits électroniques simulés constitue cependant une limite pour la méthode de relaxation d'onde, sur l'ordinateur VAX/VMS 780 de digital Equipment. En effet, pour réaliser cette simulation, le système de simulation mettant en oeuvre la méthode de relaxation d'onde utilise une mémoire vive de 25 Mo, ce qui sature la mémoire centrale de cet ordinateur. A titre de comparaison, le système de simulation de l'invention ne requiert qu'une mémoire vive de 1 Mo pour simuler un circuit de 300 transistors.

En conclusion, les avantages du système de simulation de l'invention peuvent être résumés par les points suivants :

- rapidité de calcul au moins comparable aux systèmes de simulation les plus rapides connus, pour un circuit électronique simulé de taille donnée,
- possibilité de simuler des circuits électroniques complexes beaucoup plus rapidement que les systèmes de simulation connus,
- polyvalence du système de simulation de l'invention qui peut simuler aussi bien des circuits numériques que des circuits à capacité commutée ou circuits bipolaires, ce dernier cas étant rendu possible notamment par des méthodes de calcul itératives avec sur ou sous-relaxation.

## Revendications

1. Système de simulation de circuit électronique, un tel circuit étant constitué d'un réseau avec noeuds et branches, chaque branche comprenant au moins un composant électronique, ce système de simulation comprenant un processeur (78), une mémoire morte (80) contenant des instructions destinées au processeur, une mémoire vive (82) comprenant une première zone contenant des données représentant le circuit à simuler et une deuxième zone de calcul, un circuit d'entrées-sorties (84), un bus de données (86) et un bus d'adresses (88) tous deux interconnectant le processeur (78), les mémoires (80, 82) et le circuit entrées-sorties (84), un moyen de visualisation (72) relié au circuit entrées-sorties (84) par un bus bidirectionnel (70), ce système de simulation étant caractérisé par le fait que le processeur (78), les instructions contenues dans la mémoire morte (80), et la deuxième zone de calcul de la mémoire vive (82) sont aptes à :

a) calculer le potentiel de tous les noeuds du réseau à un instant déterminé $T_n$, avec n entier compris entre 1 et N, en résolvant pour chaque noeud une équation implicite relative au potentiel de ce noeud, et en mettant en oeuvre une suite d'itérations,

b) calculer pour chaque noeud, la différence entre le potentiel calculé pour ce noeud après une itération et le potentiel de ce même noeud obtenu après l'itération précédente,

c) comparer cette différence avec un seuil prédéterminé,

d) mettre en oeuvre une nouvelle itération a) à c) ladite différence excède ledit seuil, sinon:

e) calculer par les opérations précédentes a) à d) le potentiel de tous les noeuds à l'instant suivant $T_n + 1$ défini par t'entier (n + 1) jusqu'à ce que cet entier atteigne La valeur N,

f) faire afficher sur le moyen de visualisation (72) les différentes valeurs des potentiels ainsi calculés pour tous les noeuds du circuit.

2. Système selon la revendication 1, caractérisé en ce que, lorsque, dans le calcul du potentiel d'un noeud à un instant $T_n$ par une méthode itérative, la suite des valeurs obtenues après un nombre prédéterminé d' itérations ne converge pas et est une suite monotone (croissante ou décroissante), les instructions contenues dans la mémoire morte (80) sont aptes à accélérer la convergence pour les itérations suivantes par une méthode de sur-relaxation.

3. Système selon la revendication 1, caractérisé en ce que, lorsque dans le calcul du potentiel d'un noeud à un instant $T_n$ par une méthode itérative, la suite des valeurs obtenues après un nombre prédéterminé d' itérations ne converge pas et est une suite oscillante, les instructions contenues dans la mémoire morte (80) sont aptes à accélérer la convergence pour les itérations suivantes par une méthode de sous-relaxation.

4. Système selon l'une quelconque des revendications 1 à 3, caractérisé en ce que, pour résoudre l'équation implicite relative au potentiel d'un noeud, le processeur (78) utilise la méthode du point fixe suivi d'une sécante.

5. système de simulation selon l'une quelconque des revendications 1 à 4, caractérisé en ce que, pour chaque instant fixé $T_n$, le processeur (78) déduit une valeur estimée, ou prédicteur, de la valeur du potentiel de chaque noeud à l'instant suivant $T_{n+1}$ à partir du potentiel calculé à l'instant $T_n$, ledit prédicteur étant utilisé pour initialiser le calcul itératif du potentiel dudit noeud à l'instant suivant $T_{n+1}$.

6. Système de simulation selon l'une quelconque des revendications 1 à 5, caractérisé en ce que les noeuds du circuit électronique simulé sont ordonnés suivant les dates auxquelles ils reçoivent un signal se propageant dans ledit circuit et émis par un noeud prédéterminé, le processeur calculant le potentiel des noeuds suivant cet ordre.

## Claims

1. Simulation system for an electronic circuit, such a circuit being constituted by a network with nodes and branches, each branch having at least one electronic component, said simulation system comprising a processor (78), a read-only memory (80) containing in the instructions intended for the processor, a random access memory (82) having a first zone containing data representing the circuit to be simulated and a second calculating zone, an input - output circuit (84), a data bus (86) and an address bus (88), both interconnecting the processor (78), the memories (80,82) and the input - output circuit (84), a display means (72) connected to the input - output circuit (84) by a bidirectional bus (70), said simulation system being characterized by the fact that the processor (78), the instructions contained in the read-only memory (80) and the second calculation zone of the random access memory (82) are able to:

a) calculate the potential of all the nodes of the network at a predetermined instant $T_n$, with n being an integer between 1 and N, by resolving for each node an implicit equation relative to the potential of said node and utilizing a sequence of iterations.

EP 0 198 729 B1

b) calculating for each node the difference between the potential calculated for said node following an iteration and the potential of said same node obtained after the preceding iteration,

c) comparing said difference with a predetermined threshold.

d) carrying out a new iteration (a) to c)) if said difference exceeds said threshold, if not

e) calculating by the preceding operations a) to d) whether the potential of all the nodes at the following instant $T_{n+1}$ defined by the integer $(n+1)$ until said integer reaches the value N and

f) displaying on the display means (72) the different values of the potentials calculated in this way for all the nodes of the circuit.

2. System according to claim 1, characterized in that when, in the calculation of the potential of a node at an instant $T_n$ by an iterative method, the sequence of values obtained after a predetermined number of iterations does not converge and is an increasing or decreasing monotonic sequence, the instructions contained in the read-only memory (80) are able to accelerate the convergence for the following iterations by an over-relaxation method.

3. System according to claim 1, characterized in that when, in the calculation of the potential of a node at an instant $T_n$ by an iterative method, the sequence of values obtained after a predetermined number of iterations does not converge and is an oscillating sequence, the instructions contained in the read-only memory (80) are able to speed up the convergence for the following iterations by an under-relaxation method.

4. System according to any one of the claims 1 to 3, characterized in that for solving the implicit equation relative to the potential of a node, the processor (78) uses the method of the fixed point followed by a secant.

5. Simulation system according to any one of the claims 1 to 4, characterized in that for each fixed instant $T_n$, the processor (78) deduces an estimated value or predictor of the value of the potential of each node at the following instant $T_{n+1}$ on the basis of the potential calculated at the instant $T_n$, said predictor being used for initializing the iterative calculation of the potential of said node at the following $T_{n+1}$.

6. Simulation system according to any one of the claims 1 to 5, characterized in that the nodes of the simulated electronic circuit are sequenced in accordance with the dates at which they receive a signal propagating in said circuit and emitted by a predetermined node, the processor calculating the potential of the nodes in said sequence.

**Ansprüche**

1. System zur Simulation einer elektronsichen Schaltung, wobei eine solche Schaltung aus einem Netz mit Knoten und Zweigen gebildet ist und jeder Zweig wenigstens ein elektronisches Bauelement enthält, wobei das Simulationssystem einen Prozessor (78), einen Festspeicher (80), der für den Prozessor bestimmte Befehle enthält, einen Lebendspeicher (82), der eine erste Zone aufweist, die Daten enthält, die die zu simulierende Schaltung repräsentieren, sowie eine zweite Rechenzone aufweist, eine Eingangs-Ausgangs-Schaltung (84), einen Datenbus (86) und einen Adressenbus (88) enthält, die zusammen den Prozessor (78), die Speicher (80,82) und die Eingangs-Ausgangs-Schaltung (84) miteinander verbinden, mit einer Anzeigeeinrichtung (72), die mit der Eingangs-Ausgangs-Schaltung (84) dich einen bidirektionalen Bus (70) verbunden ist, wobei das Simulationssystem **dadurch gekennzeichnet** ist, daß der Prozessor (78), die in dem Festspeicher (80) enthaltenen Befehle und die zweite Rechenzone des Lebendspeichers (82) dazu eingerichtet sind,

a) das Potential aller Knoten des Netzes zu einem bestimmten Zeitpunkt $T_n$ zu berechnen, wobei n eine ganze Zahl zwischen 1 und N ist, indem für jeden Knoten eine für das Potential dieses Knotens implizierte Gleichung gelöst wird und man eine Folge von Iterationen ausführt,

b) für jeden Knoten die Differenz zwischen dem für diesen Knoten nach einer Iteration berechneten Potential und dem Potential desselben Knotens zu berechnen, das man nach der vorangehenden Iteration erhält,

c) diese Differenz mit einem vorbestimmten Schwellenwert zu vergleichen,

d) eine neue Iteration von a) bis c) auzuführen, wenn die genannte Differenz den genannten Schwellenwert überschreitet, und im Verneinungsfalle

13

EP 0 198 729 B1

e) durch die vorangehenden Operationen a) bis d) das Potential aller Knoten im nachfolgenden Zeitpunkt $T_{n+1}$ zu berechnen, der durch die ganze Zahl (n + 1) bestimmt wird, bis diese ganze Zahl den Wert N erreicht,

f) auf der Anzeigeeinrichtung (72) die verschiedenen, so für alle Knoten der Schaltung berechneten Potentialwerte anzuzeigen.

2. System nach Anspruch 1, **dadurch gekennzeichnet**, daß, wenn die Berechnung des Potential eines Knotens zu einem Zeitpunkt $T_n$ durch ein iteratives Verfahren die Folge der nach einer vorbestimmten Anzahl von Iterationen erhaltenen Werte nicht konvergiert und eine monotone Reihe (zunehmend oder abnehmend) ist, die in dem Festspeicher (80) enthaltenen Befehle dazu eingerichtet sind, die Konvergenz für die nachfolgenden Iterationen nach einem Über-Relaxationsverfahren zu beschleunigen.

3. System nach Anspruch 1, **dadurch gekennzeichnet**, daß, wenn in der Berechnung des Potentials eines Knotens zu einem Zeitpunkt $T_n$ nach einem iterativen Verfahren die Folge der erhaltenen Werte nach einer vorbestimmten An zahl von Iterationen nicht konvergiert und eine oszillierende Reihe ist, die in dem Festspeicher (80) enthaltenen Befehle dazu eingerichtet sind, die Konvergenz für die nachfolgenden Iterationen nach einem Unter-Relaxationsverfahren zu beschleunigen.

4. System nach einem der Ansprüche 1 bis 3, **dadurch gekennzeichnet**, daß zum Auflösen der für ein Potential eines Knotens implizierten Gleichung der Prozessor (78) das Verfahren des festen Punktes gefolgt von einer Sekante verwendet.

5. Simulationsverfahren nach einem der Ansprüche 1 bis 4, **dadurch gekennzeichnet**, daß für jeden festen Zeitpunkt $T_n$ der Prozessor (78) einen abgeschätzten oder vorbestimmten Wert von dem Potentialwert eines jeden Knotens zum nachfolgenden Zeitpunkt $T_{n+1'}$ ausgehend vom zum Zeitpunkt $T_n$ berechneten Potential abzieht, wobei der vorbestimmte Wert dazu verwendet wird, die iterative Berechnung des Potentials des genannten Knotens zum nachfolgenden Zeitpunkt $T_{n+1}$ auszulösen.

6. Simulationsverfahren nach einem der Ansprüche 1 bis 5, **dadurch gekennzeichnet**, daß die Knoten der simulierten elektronischen Schaltung nach den Daten geordnet sind, bei denen sie ein Signal empfangen, das sich in der Schaltung ausbreitet und von einem vorbestimmten Knoten ausgeht, wobei der Prozessor das Potential der Knoten nach dieser Reihenfolge berechnet.

14

**2** DEBUT

**4** i=1

**6** j=1

**8** n=1

**10** résolution de $\quad {}^{j}F({}^{j}v_n^i)=0$

calcul de $\quad {}^{j}e_n^i = |{}^{j}v_n^i - {}^{j}v_n^{i-1}|$

mémorisation de $\quad {}^{j}v_n^i$ et ${}^{j}e_n^i$

**12** n=1

OUI

NON

**14** ${}^{j}e^i = {}^{j}e_1^i$

**16** ${}^{j}e^i = MAX({}^{j}e_n^i, {}^{j}e^i)$

**20** n=n+1

NON

**18** n=N

OUI

**22** j=1

OUI

NON

**24** $d^i = {}^{1}e^i$

**26** $d^i = \max(d^i, {}^{j}e^i)$

**30** j=j+1

NON

**28** j=p

OUI

**34** i=i+1

NON

**32** $d^i < \delta$

OUI

**36** FIN

FIG.1

FIG.2

FIG.3a

FIG.3b

FIG.4

FIG.6

$A_8$ $A_7$ $A_6$ $A_5$

$V_{on}$

$V_{on}$

$V_{off}$ $S_A$ $V_{off}$

$A_3$
$A_2$
$A_1$
$A_0$

FIG.5a

FIG.5b

FIG.5c

# FIG.7a

# FIG.7b

FIG.8